# EUROPEAN PATENT APPLICATION

(11) **EP 2 579 319 A1**
(43) Date of publication of application: **10.04.2013**
(21) Application number: 11786538.6
(22) Date of filing: 18.05.2011
(51) Int. Cl.: H01L 31/0224

(54) **SOLAR CELL MODULE AND SOLAR CELL**

(30) Priority: 28.05.2010 JP 2010122986
(71) Applicant: Sanyo Electric Co., Ltd., Osaka 570-8677 (JP)
(72) Inventor: TOHODA Satoshi, Moriguchi-shi Osaka 570-8677 (JP)
(74) Representative: Calderbank, Thomas Roger
(86) International application number: PCT/JP2011/061426
(87) International publication number: WO 2011/148839

(57) **Abstract**

[Problem]

An objective is to further improve the durability against temperature changes of a solar cell module in which solar cells and a wiring material are bonded together using a resin adhesive.

[Solution]

Electrode 21 includes finger electrode 22 extending in direction y orthogonal to a direction in which wiring material 11 extends, and includes extended electrode 24. Extended electrode 24 is at least partly positioned between photoelectric conversion body 20 and wiring material 11. Extended electrode 24 extends from finger electrode 22, in a direction inclined with respect to direction y in which finger electrode 22 extends. Extended electrode 24 is thicker than finger electrode 22.

## Description

### TECHNICAL FIELD

The invention relates to a solar cell module and a solar cell.

### BACKGROUND ART

Recently, a solar cell module has been receiving much attention as an energy source imposing a small environmental load.

Generally, a solar cell module includes a plurality of solar cells. The plurality of solar cells are electrically connected with each other in series or in parallel through a wiring material.

Conventionally, solder has been widely used for bonding the solar cell and the wiring material together. However, the bonding of the solar cell and the wiring material to each other using the solder requires the solder to be melted. Thus, in the bonding step, the temperature of the solar cell becomes high. As a result, the solar cell might be damaged or deformed.

In view of this situation, the use of a conductive resin adhesive for bonding the solar cell and the wiring material together has been recently under consideration (see, for example Patent Document 1).

When the solar cell and the wiring material are bonded together using a resin adhesive such as a conductive resin adhesive, the temperature during the bonding step can be made low unlike in the case where the solder is used for the adhesion. Thus, the solar cell can be prevented from having damage, deformation, or the like in the step of bonding the wiring material.

### PRIOR ART DOCUMENT

### PATENT DOCUMENT

PATENT DOCUMENT 1: Japanese Patent Application Publication No. 2009-295940

### SUMMARY OF THE INVENTION

### PROBLEMS TO BE SOLVED BY THE INVENTION

Recently, solar cell modules have been required to achieve higher and higher standard of durability against temperature changes.

The invention is made in view of the above points and an objective thereof is to further improve the durability against temperature changes of a solar cell module in which solar cells and a wiring material are to be bonded together using a resin adhesive, and to provide a solar cell usable in such a solar cell module.

### MEANS FOR SOLVING THE PROBLEM

A solar cell module according to the invention includes a plurality of solar cells, a wiring material having a thin and long shape, and a resin adhesive. The plurality of solar cells each includes a photoelectric conversion body and an electrode. The electrode is formed on a surface of the photoelectric conversion body. The wiring material electrically connects the plurality of solar cells. The resin adhesive bonds the solar cell and the wiring material together. The electrode includes a finger electrode and an extended electrode. The finger electrode extends in a direction orthogonal to a direction in which the wiring material extends. The extended electrode is at least partly positioned between the photoelectric conversion body and the wiring material. The extended electrode extends from the finger electrode, in a direction inclined with respect to a direction in which the finger electrode extends. The extended electrode is thicker than the finger electrode

In the invention, "being inclined" includes "being orthogonal".

The extended electrode is preferably in parallel with the direction in which the wiring material extends.

A thickness of the extended electrode is preferably 1.1 or more times thicker than the finger electrode.

The extended electrode is preferably in direct contact with the wiring material.

A resin adhesive is preferably provided in at least a part of a portion between the finger electrode and the wiring material.

In the invention, the electrode may include the finger electrode comprising a plurality of finger electrodes, and the electrode further may include a bus bar electrically connected to the finger electrodes and at least partly positioned between the photoelectric conversion body and the wiring material. In such a case, the extended electrode is preferably thicker than the bus bar.

A solar cell according to the invention includes a photoelectric conversion body and an electrode formed on a surface of the photoelectric conversion body and being a portion to which a wiring material is to be connected. The electrode includes a plurality of finger electrodes extending in one direction and an extended electrode extending in a direction inclined with respect to the direction in which the finger electrodes extend. The extended electrode is an electrode to which the wiring material is to be connected. The extended electrode is thicker than the finger electrode.

### EFFECT OF THE INVENTION

According to the invention, durability against temperature of a solar cell module in which solar cells and a wiring material are bonded together using a resin adhesive can be further improved, and a solar cell usable in such a solar cell module can be provided.

### BRIEF DESCRIPTION OF THE DRAWINGS

[Fig. 1] Fig. 1 is a schematic cross-sectional view of a solar cell module according to a first embodiment.
[Fig. 2] Fig. 2 is a schematic plan view of a solar cell viewed from a light-receiving surface side.
[Fig. 3] Fig. 3 is an enlarged schematic plan view of a portion III in Fig. 2.
[Fig. 4] Fig. 4 is a schematic cross-sectional view taken along a line IV-IV in Fig. 3.
[Fig. 5] Fig. 5 is a schematic cross-sectional view taken along a line V-V in Fig. 3.
[Fig. 6] Fig. 6 is a schematic cross-sectional view taken along a line VI-VI in Fig. 3.
[Fig. 7] Fig. 7 is a partially-enlarged schematic cross-sectional view of a solar cell module according to Comparative Example in which no extended electrode is provided.
[Fig. 8] Fig. 8 is a partially-enlarged schematic cross-sectional view of a solar cell module according to Comparative Example in which no extended electrode is provided.
[Fig. 9] Fig. 9 is a schematic cross-sectional view taken along a line IV-IV in Fig. 3.
[Fig. 10] Fig. 10 is a schematic plan view for describing a configuration of an electrode in a solar cell module according to a first modification.
[Fig. 11] Fig. 11 is a schematic plan view for describing a configuration of an electrode in a solar cell module according to a second modification.
[Fig. 12] Fig. 12 is a schematic plan view for describing a configuration of an electrode in a solar cell module according to a third modification.
[Fig. 13] Fig. 13 is a schematic plan view for describing a configuration of an electrode in a solar cell module according to a fourth modification.

### DETAILED DESCRIPTION OF EMBODIMENTS

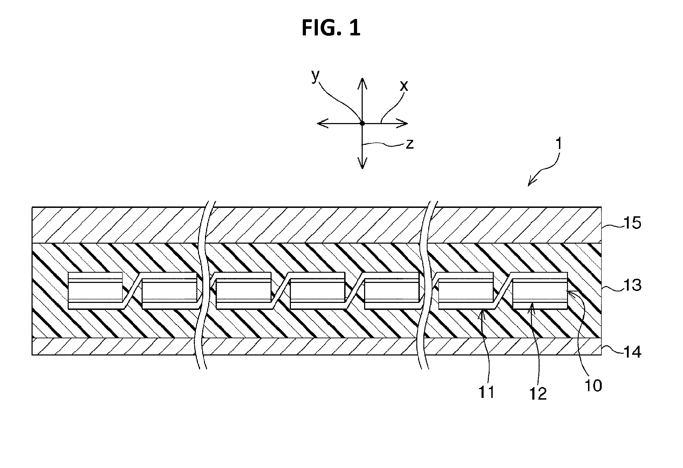

Preferred embodiments of the invention are described with solar cell module 1 shown in Fig.1 as an example. It is to be noted that solar cell module 1 is merely an example, and the solar cell module according to the invention is not particularly limited to solar cell module 1.

In the drawings referred to in embodiments and modifications, the same reference sign denote materials having substantially the same function. In addition, it should be noted that the drawings referred to in embodiments and the like are schematic and ratios of dimensions and the like of an object in the drawings might be different from actual ones. Moreover, the drawings also include objects having different ratios of dimensions. Therefore, specific ratios of dimensions and the like should be determined in consideration of the following description.

### (Overall Configuration of Solar Cell Module 1)

Fig. 1 is a schematic cross-sectional view of a solar cell module according to an embodiment of the invention. First of all, overall configuration of solar cell module 1 is described with reference to Fig.1.

As shown in Fig. 1, solar cell module 1 includes solar cells 10 arranged along arrangement direction x. Solar cells 10 are electrically connected with each other through wiring materials 11. Specifically, solar cells 10 are electrically connected in series or in parallel with adjacent solar cells 10 being electrically connected with each other through wiring materials 11.

First and second protecting materials 14 and 15 are respectively disposed on light-receiving surface and back surface sides of solar cells 10. Sealing material 13 is disposed between first protecting material 14 and second protecting material 15. Solar cells 10 are sealed by sealing material 13.

Materials of sealing material 13 as well as first and second protecting materials 14 and 15 are not particularly limited. For example, sealing material 13 may be made of a translucent resin such as ethylene-vinyl acetate (EVA) copolymer and polyvinyl butyral (PVB).

For example, first and second protecting materials 14 and 15 may be made of glass, resin, or the like. Alternatively, for example, one of first and second protecting materials 14 and 15 may be made of a resin film in which a metal foil such as an aluminum foil is interposed. In this embodiment, first protecting material 14 is disposed on the back surface side of solar cell 10 and is made of the resin film in which a metal foil such as an aluminum foil is interposed. Second protecting material 15 is disposed on the light-receiving surface side of solar cell 10 and is made of glass or a translucent resin.

A terminal box may be provided on a surface of first protecting material 14.

### (Configuration of Solar Cell 10)

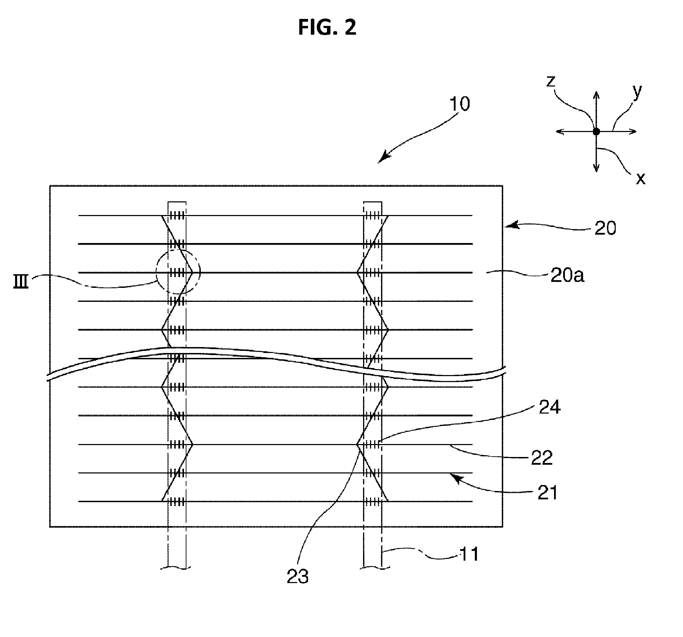

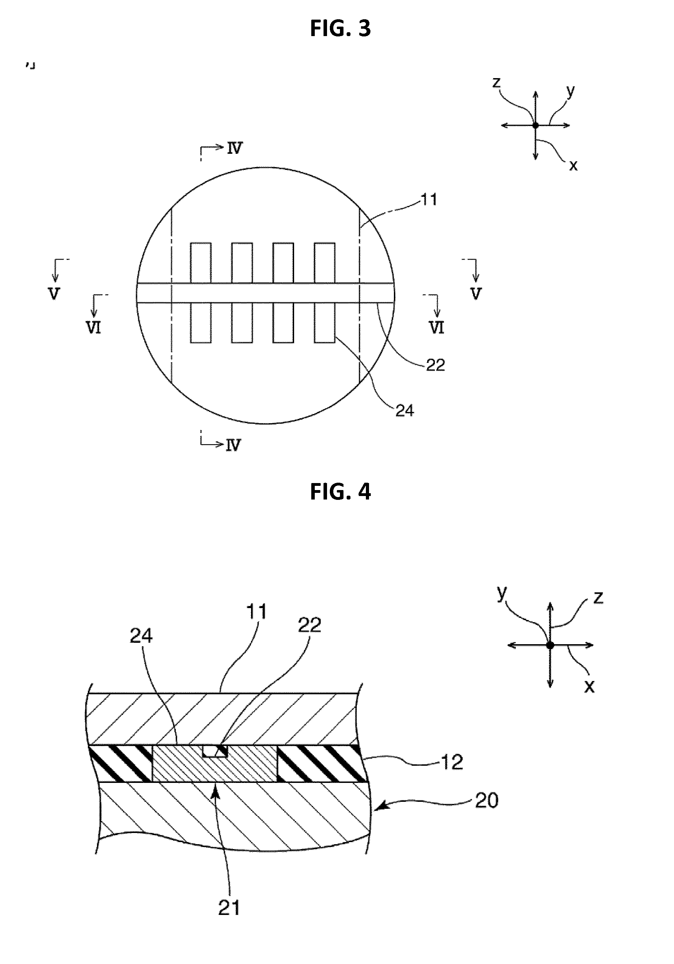

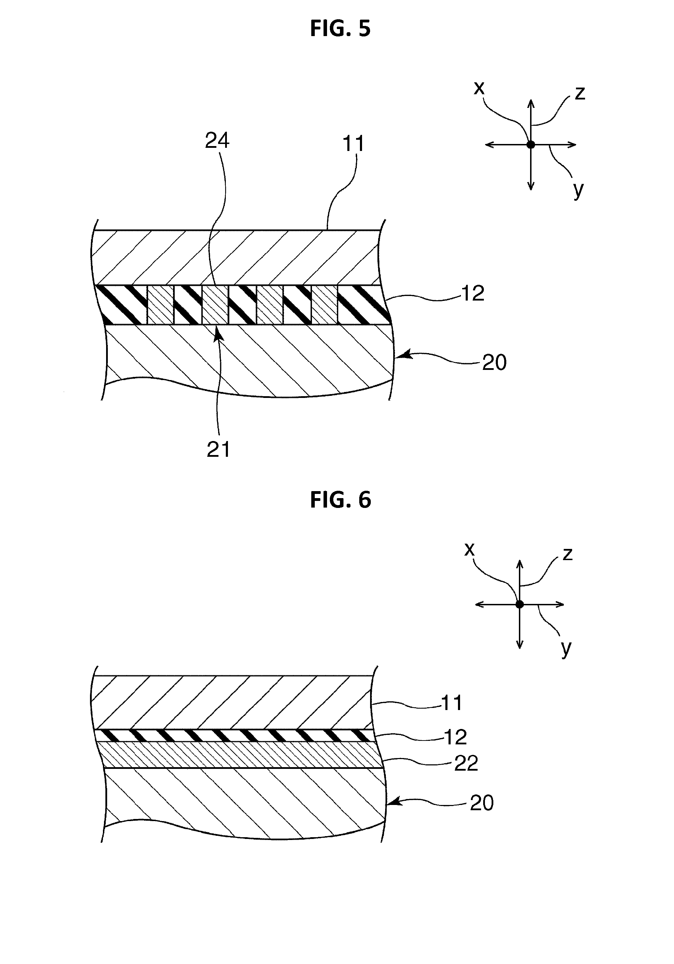

Fig. 2 is a schematic plan view of a solar cell viewed from a light-receiving surface side. Fig. 3 is an enlarged schematic plan view of a portion III in Fig. 2. Fig. 4 is a schematic cross-sectional view taken along a line IV-IV in Fig. 3. Fig. 5 is a schematic cross-sectional view taken along a line V-V in Fig. 3. Fig. 6 is a schematic cross-sectional view taken along a line VI-VI in Fig. 3. The configuration of solar cell 10 is described with reference to Fig. 2 to Fig. 6.

Solar cell 10 described herein is merely an example. In the invention, the type and the configuration of the solar cell are not particularly limited.

In this embodiment, one of the main surfaces of the solar cell 10 is the light-receiving surface and the other main surface is the back surface. Alternatively, both main surfaces of the solar cell may be the light-receiving surfaces. In such a case, each of first and second protecting materials 14 and 15 preferably has translucency.

### (Photoelectric Conversion Body 20)

As shown in Fig. 2, solar cell 10 includes photoelectric conversion body 20 that generates carriers (electrons and holes) upon receiving light.

Photoelectric conversion body 20 is made of a semiconductor material with a semiconductor junction such as HIT (registered trademark) junction, pn junction, or pin junction. For example, the semiconductor material includes a crystalline silicon semiconductor such as a single crystal silicon, a polycrystal silicon, or the like, an amorphous silicon semiconductor, and a compound semiconductor such as GaAs.

### (Overview of Electrode 21)

Electrode 21 is formed at least on light-receiving surface 20a of photoelectric conversion body 20. Specifically, although omitted in the drawing, electrode 21 is formed on light-receiving surface 20a of photoelectric conversion body 20 and is also formed on the back surface of photoelectric conversion body 20.

As shown in Fig. 2, electrode 21 includes a plurality of finger electrodes 22, a plurality of bus bars 23, and a plurality of extended electrodes 24. In this embodiment, the plurality of finger electrodes 22, the plurality of bus bars 23, and the plurality of extended electrodes 24 are integrally formed. The detail of the configuration of electrode 21 is described after how solar cells 10 are electrically connected through wiring material 11 is described.

### (Electrical Connection of Solar Cells 10 through Wiring Material 11)

As shown in Fig. 1, solar cells 10 adjacently arranged are electrically connected with each other through wiring material 11. Specifically, wiring material 11 has a thin and long shape. More specifically, in this embodiment, wiring material 11 has a linear shape. Wiring material 11 extends in arrangement direction x. One end of wiring material 11 is electrically connected to electrode 21 on the light-receiving surface 20a side of solar cell 10, while the other end of wiring material 11 is electrically connected to electrode 21 on the back surface side of solar cell 10 adjacent to solar cell 10 mentioned above. Thus, solar cells 10 adjacently arranged are electrically connected through wiring material 11.

Wiring material 11 is not particularly limited as long as it is conductive. For example, wiring material 11 may include a wiring material main body and a coating layer by which the wiring material main body is coated. For example, the wiring material main body may be made of a metal material such as Cu. For example, the coating layer may be made of metal such as Ag or an alloy such as solder.

As shown in Fig. 1 and Fig. 4, wiring material 11 and solar cell 10 are bonded together by resin adhesive 12. Specifically, in this embodiment, wiring material 11 and solar cell 10 are bonded together by resin adhesive 12, while electrode 21 of solar cell 10 and wiring material 11 are in direct contact with each other. Thus, in this embodiment, electrode 21 and wiring material 11 are electrically connected by being in direct contact with each other. Thus, resin adhesive 12 is made of an insulating resin such as epoxy resin, acryl resin, polyimide resin, phenol resin, urethane resin, silicone resin, or mixture or copolymer of these resins for example.

In the invention, the resin adhesive may not have insulating property. For example, the resin adhesive may be an anisotropic conductive resin adhesive in which conductive particles are dispersed in an insulating resin. In such a case, the electrode and the wiring material may not necessarily be in direct contact with each other. The electrode and the wiring material may be electrically connected with each other through the conductive particles.

If the resin adhesive is the anisotropic conductive resin adhesive, for example, the insulating resin may be epoxy resin, acryl resin, polyimide resin, phenol resin, urethane resin, silicone resin, or a mixture or copolymer of these resins. The conductive particles may be particles of a metal such as nickel, copper, silver, aluminum, tin, gold, or an alloy including one or more of these metals. Alternatively, the conductive particles may be insulating particles provided with a conductive coating such as metal coating or alloy coating.

### (Detail of Electrode 21)

As shown in Fig. 2, finger electrodes 22 each extend in direction y orthogonal to arrangement direction x in which wiring material 11 extends to be parallel with each other. Finger electrodes 22 are arranged in parallel with each other along arrangement direction x. In the invention, "orthogonal" includes substantially orthogonal. Specifically, in the invention, it is regarded as being "orthogonal" as long as it is within the range of 90°±5°.

Bus bars 23 are formed in a zigzag form along arrangement direction x. Finger electrodes 22 are electrically connected with each other through bus bar 23. In this embodiment, bus bar 23 is at least partly positioned between photoelectric conversion body 20 and wiring material 11.

In this embodiment, a case is described where the bus bar is formed in a zigzag form. However, the invention is not limited to this configuration. In the invention, the bus bar may be formed in linear shape for example. For example, the bus bar may not be formed in the invention. Specifically, the invention is not particularly limited as long as at least one finger electrode and extended electrode is provided.

In this embodiment, the plurality of extended electrodes 24 are provided to each of the plurality of finger electrodes 22. Extended electrode 24 is electrically connected to finger electrode 22. As shown in Fig. 2 and Fig. 3 extended electrode 24 extends from finger electrode 22 and in a direction inclined with respect to direction y in which finger electrode 22 extends. Specifically, in this embodiment, extended electrode 24 extends in a direction orthogonal to direction y in which finger electrode 22 extends and in parallel with direction x in which wiring material 11 extends.

As shown in Fig. 2, extended electrode 24 is at least partly positioned between photoelectric conversion body 20 and wiring material 11. Specifically, in this embodiment, entire extended electrode 24 is positioned between photoelectric conversion body 20 and wiring material 11. Thus, in this embodiment, extended electrode 24, and part of finger electrode 22 and part of bus bar 23 are positioned between photoelectric conversion body 20 and wiring material 11.

In this embodiment, extended electrode 24 is thicker than finger electrode 22 as shown in Fig. 4 to Fig. 6.

In this embodiment, extended electrode 24 is thicker than bus bar 23. In this embodiment, the thickness of bus bar 23 is substantially the same with that of finger electrode 22.

Thus, in this embodiment, extended electrodes 24 in electrode 21 are in direct contact with wiring material 11. Accordingly, electrode 21 is electrically connected to wiring material 11 at extended electrodes 24. Resin adhesive 12 is provided in at least part of a portion between wiring material 11, and finger electrode 22 and bus bar 23. Therefore, wiring material 11, and finger electrode 22 and bus bar 23 are at least partly bonded by resin adhesive 12.

### (Method for Producing Solar Cell Module 1)

Next, a method for manufacturing solar cell module 1 is described in detail.

First, photoelectric conversion body 20 is prepared. Photoelectric conversion body 20 can be produced by a known method.

Next, electrode 21 is formed on each of light-receiving surface 20a and the back surface of photoelectric conversion body 20, and thus solar cell 10 is completed. A method for forming electrode 21 is not particularly limited. Electrode 21 can be formed by printing a conductive paste by screen printing for example.

Then, solar cells 10 prepared as described above are electrically connected with each other through wiring material 11. Specifically, wiring material 11 is disposed on solar cell 10 with resin adhesive 12 provided in between, and wiring material 11 is relatively pressed against the side of solar cell 10. Thus, wiring material 11 and solar cell 10 are bonded together. By repeating the bonding of solar cell 10 and wiring material 11, solar cells 10 are electrically connected with each other.

Next, sealing material 13 and first and second protecting materials 14 and 15 shown in Fig. 1 are prepared. For example, a resin sheet such as an EVA sheet is placed on second protecting material 15. Solar cells 10 electrically connected with each other through wiring material 11 are disposed on the resin sheet. A resin sheet such as an EVA sheet is placed on solar cells 10, and first protecting material 14 is placed on the resin sheet. These are tacked together by being pressed and heated in decompressed atmosphere, and then are heated again so that resin in the resin sheets is cross-linked, and thus sealing material 13 is formed. Through the above described steps, solar cell module 1 can be produced.

A terminal box, a metal frame, and the like may be attached if needed.

Solar cell 10, photoelectric conversion body 20, and wiring material 11 have different thermal expansion rates. Thus, if a temperature of solar cell module 1 changes, wiring material 11 contracts or expands relative to photoelectric conversion body 20. Generally, wiring material 11 has a larger thermal-expansion rate than photoelectric conversion body 20. Thus, if the temperature of solar cell module 1 rises, wiring material 11 expands relative to photoelectric conversion body 20, and if the temperature of solar cell module 1 drops, wiring material 11 contracts relative to photoelectric conversion body 20. Thus, the temperature change of solar cell module 1 produces stress between wiring material 11 and photoelectric conversion body 20.

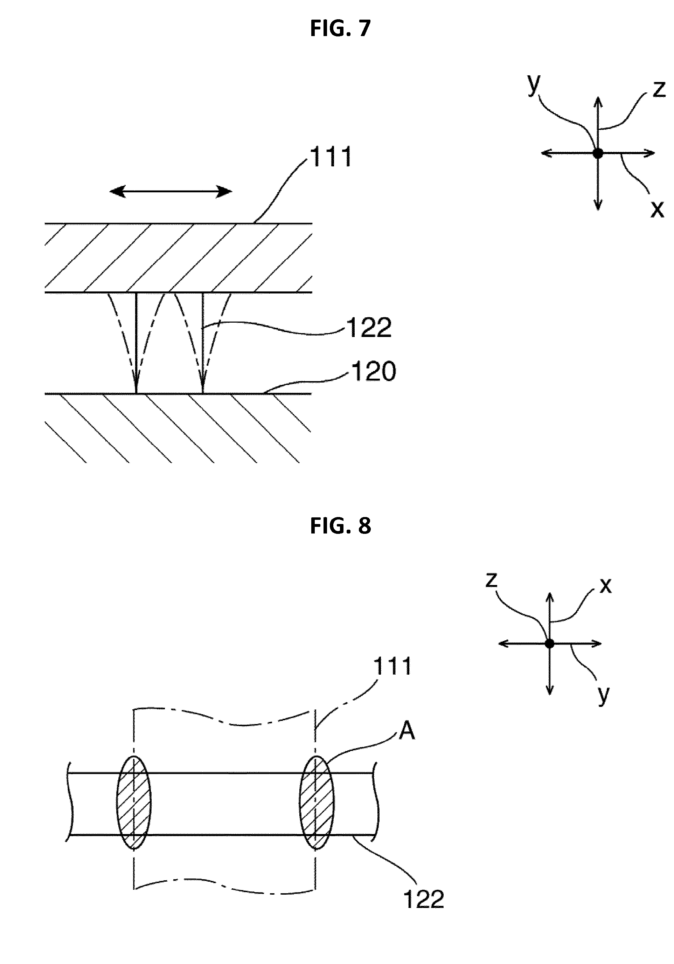

Here, a case where the extended electrode is not provided is considered. As shown in Fig. 7, when wiring material 111 expands or contracts relative to photoelectric conversion body 120, finger electrode 122, which is short in size in direction y while extending in direction y orthogonal to direction x, largely deforms in direction x. Thus, large stress is applied to portions of finger electrode 122 in regions A and is likely to break finger electrode 122. Thus, finger electrode 122 needs to be formed wide so as not to be broken. However, if finger electrode 122 is formed wide, the amount of light that reaches photoelectric conversion body 20 is small, and the output of solar cell module 1 is low.

In contrast, in this embodiment, extended electrodes 24 thicker than finger electrode 22 are provided. Electrode 21 is in contact with wiring material 11 at extended electrodes 24, and thus at least part of finger electrode 22 is not in direct contact with wiring material 11. Thus, even when wiring material 11 expands or contracts relative to photoelectric conversion body 20, stress is less likely to be directly applied to finger electrode 22. Accordingly, even if finger electrode 22 is thin, finger electrode 22 is less likely to break. Similarly, stress is less likely to be directly applied to bus bar 23 also, and thus bus bar 23 is also less likely to break.

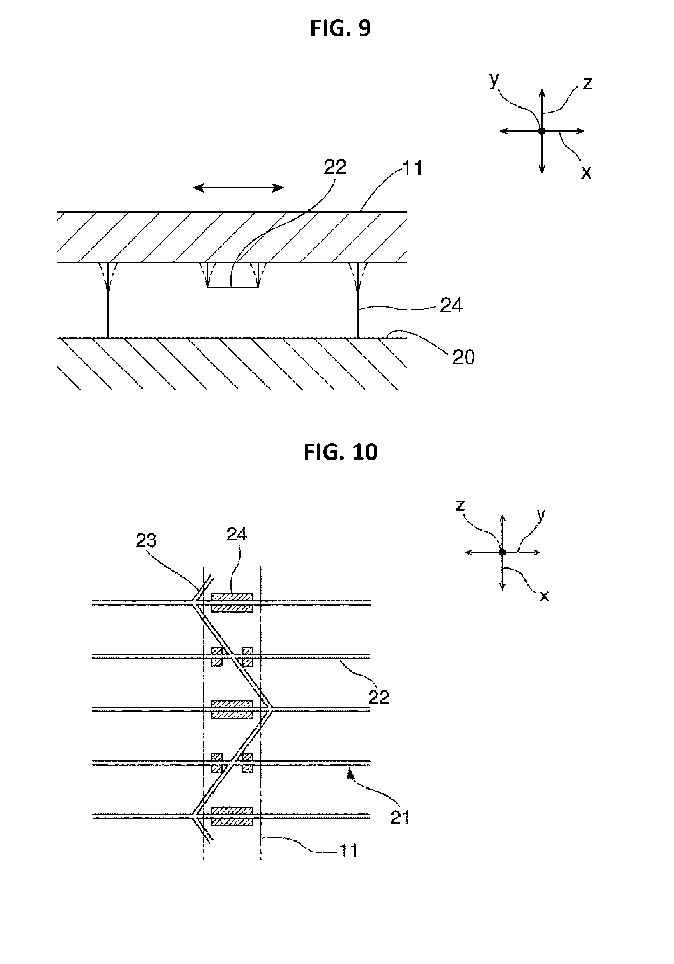

In this embodiment, when wiring material 11 expands or contracts relative to photoelectric conversion body 20, stress is applied to extended electrodes 24. Extended electrode 24 extends in a direction inclined with respect to direction y in which finger electrode 22 extends. That is, the direction in which extended electrode 24 extends is not orthogonal to arrangement direction x in which wiring electrode 11 expands or contracts. Specifically, in this embodiment, extended electrode 24 is formed to be in parallel with arrangement direction x in which wiring electrode 11 expands or contracts. Thus, as shown in Fig. 9, extended electrode 24 is long in arrangement direction x in which wiring electrode 11 expands or contracts. Thus, extended electrode 24 has a high rigidity against the stress in arrangement direction x. Thus, extended electrode 24 is less likely to break even when wiring electrode 11 expands or contracts relative to photoelectric conversion body 20.

Thus, since extended electrodes 24 are provided, in this embodiment, even when finger electrode 22 and bus bar 23 are thin, electrode 21 is less likely to break when the temperature of solar cell module 1 changes. Accordingly, the durability against temperature of solar cell module 1 can be improved and output of solar cell module 1 can be increased.

This effect of improving the durability against temperature is generally obtained when extended electrode 24 is thicker than finger electrode 22. However, if the difference in thickness between extended electrode 24 and finger electrode 22 is too small, the stress is likely to be applied to finger electrode 22 in some cases. Thus, the difference in thickness between extended electrode 24 and finger electrode 22 is preferably 0.1 µm or more before the connection of wiring material 11. On the other hand, if extended electrode 24 is too thick, extended electrode 24 or solar cell 10 might be damaged during the connection of wiring material 11. The difference in thickness between extended electrode 24 and finger electrode 22 is preferably not larger than 50 µm, more preferably not larger than 30 µm, and even more preferably not larger than 20 µm.

Similarly, the difference in thickness between extended electrode 24 and bus bar 23 is preferably 0.1 µm or more. The difference in thickness between extended electrode 24 and bus bar 23 is preferably not larger than 50 µm, more preferably not larger than 30 µm, and even more preferably not larger than 20 µm. The differences in thickness can be obtained from a 3D profile of an SEM measurement device.

In this embodiment, finger electrode 22 and bus bar 23 are thinner than extended electrode 24. Thus, resin adhesive 12 is provided in at least part of a portion between finger electrode 22 and bus bar 23, and wiring material 11. Thus, finger electrode 22 and bus bar 23, and wiring material 11 are bonded together by resin adhesive 12. Thus, finger electrode 22 and bus bar 23 have the same height as extended electrode 24. Accordingly, bonding strength of wiring material 11 can be increased from a case where end surfaces of finger electrode 22 and bus bar 23 are not bonded to wiring material 11 by resin adhesive 12. Accordingly, mechanical endurance of solar cell module 1 can be improved.

### (First to Fourth Modifications)

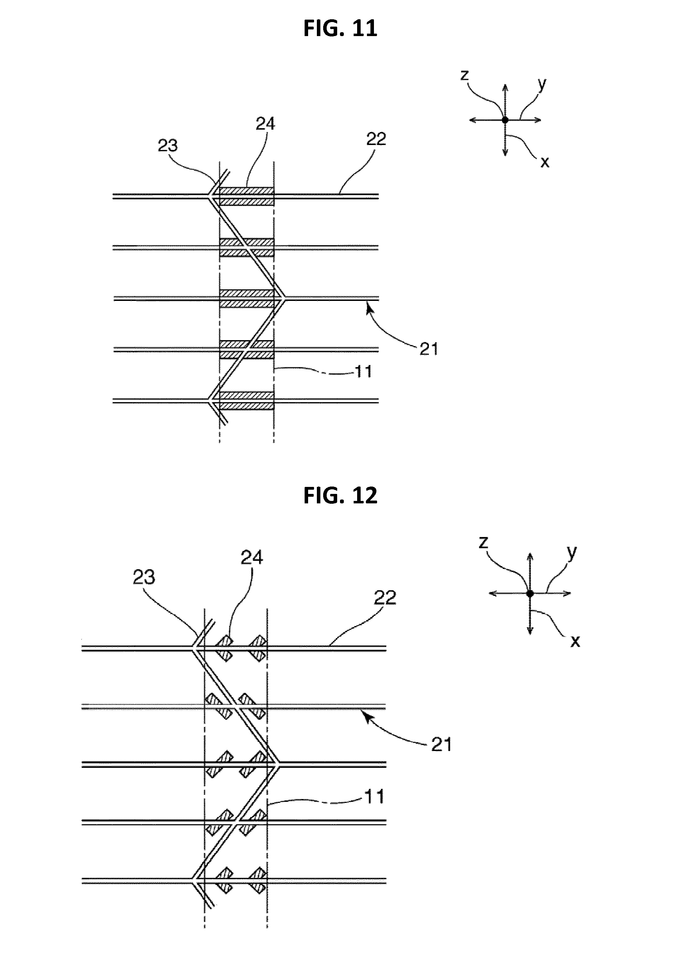

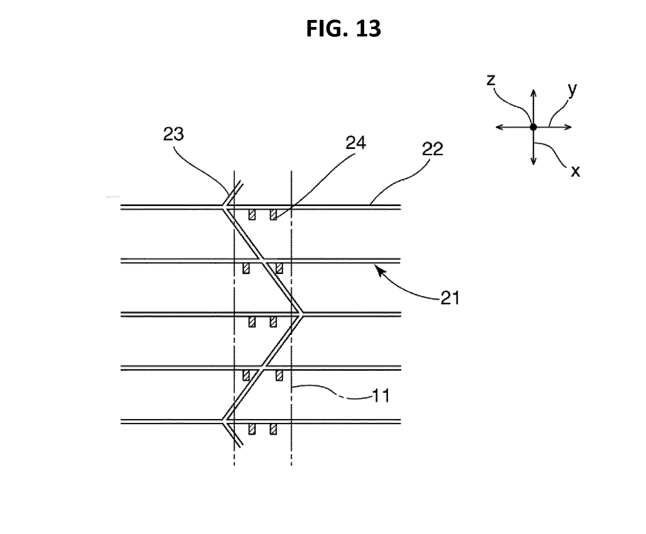

Fig. 10 is a schematic plan view for describing a configuration of an electrode in a solar cell module according to a first modification. Fig. 11 is a schematic plan view for describing a configuration of an electrode in a solar cell module according to a second modification. Fig. 12 is a schematic plan view for describing a configuration of an electrode in a solar cell module according to a third modification. Fig. 13 is a schematic plan view for describing a configuration of an electrode in a solar cell module according to a fourth modification. In Fig. 10 to Fig. 13, a portion in which the extended electrodes are provided is hatched for the convenience of description.

In the first embodiment, the case is described where the plurality of thin and long extended electrodes 24 are provided on both side of each of the plurality of finger electrodes 22 to be in parallel with direction x. However, the present invention is not limited to this configuration.

For example, as shown in Fig. 10, one extended electrode 24 may be provided to at least one finger electrode 22. In such a case, extended electrode 24 is preferably wide in direction y.

Alternatively, as shown in Fig. 11, one extended electrode 24 may be provided to each of the plurality of finger electrodes 22.

Alternatively, for example, as shown in Fig. 12, extended electrodes 24 may be inclined toward arrangement direction x and direction y. In Fig. 12, extended electrodes 24 are provided to be in parallel with bus bar 23.

For example, as shown in Fig. 13, extended electrode 24 may be provided only on one side of finger electrodes 22 in arrangement direction x.

### DESCRIPTION OF REFERENCE NUMERALS

- 1 ...: solar cell module
- 10 ...: solar cell
- 11 ...: wiring material
- 12 ...: resin adhesive
- 13 ...: sealing material
- 14 ...: first protecting material
- 15 ...: second protecting material
- 20 ...: photoelectric conversion body
- 20a ...: light-receiving surface of photoelectric conversion body
- 21 ...: electrode
- 22 ...: finger electrode
- 23 ...: bus bar
- 24 ...: extended electrode

## Claims

1. A solar cell module comprising:
solar cells each including a photoelectric conversion body and an electrode formed on a surface of the photoelectric conversion body; and
a wiring material electrically connecting the solar cells, wherein
the electrode includes:
a finger electrode extending in a direction orthogonal to a direction in which the wiring material extends; and
an extended electrode at least partly positioned between the photoelectric conversion body and the wiring material, and extending from the finger electrode, in a direction inclined with respect to the direction in which the finger electrode extends, and
the extended electrode is thicker than the finger electrode.

2. The solar cell module according to claim 1, wherein the extended electrode is in parallel with the direction in which the wiring material extends.

3. The solar cell module according to claim 1, wherein the extended electrode is thicker by 1.1 or more times than the finger electrode.

4. The solar cell module according to claim 1, wherein the electrode is electrically connected to the wiring material at the extended electrode.

5. The solar cell module according to claim 4, wherein the extended electrode is in direct contact with the wiring material.

6. The solar cell module according to claim 1 further comprising a resin adhesive provided in at least a part of a portion between the finger electrode and the wiring material.

7. The solar cell module according to claim 1, wherein the electrode includes the finger electrode comprising a Not Highlight plurality of finger electrodes, and
the electrode further includes a bus bar electrically connected to the finger electrodes and at least partly positioned between the photoelectric conversion body and the wiring material.

8. The solar cell module according to claim 7, wherein the extended electrode is thicker than the bus bar.

9. A solar cell comprising:
a photoelectric conversion body; and
an electrode formed on a surface of the photoelectric conversion body, wherein a wiring material is to be connected to the electrode, wherein
the electrode includes:
finger electrodes extending in a direction; and
an extended electrode extending in a direction inclined with respect to the direction in which the finger electrodes extend,
the extended electrode is an electrode to which the wiring material is to be connected, and
the extended electrode is thicker than the finger electrode.

10. The solar cell according to claim 9, wherein the extended electrode is thicker by 1.1 or more times than the finger electrodes.

11. The solar cell according to claim 9, wherein the extended electrode extends in a direction orthogonal to the direction in which the finger electrodes extend.

12. The solar cell according to claim 9 further comprising a bus bar electrode electrically connected to the finger electrodes.

13. The solar cell according to claim 12, wherein the extended electrode is thicker than the bus bar electrode.
